# EUROPEAN PATENT APPLICATION

(11) **EP 4 664 124 A1**
(43) Date of publication of application: **17.12.2025**
(21) Application number: 25176043.5
(22) Date of filing: 13.05.2025
(51) Int. Cl.: G01R 31/28, G01R 31/3185

(54) **FLEXIBLE PATTERN TESTING FOR D2D LINK PATHS**

(30) Priority: 14.06.2024 US 202418743636
(71) Applicant: INTEL Corporation, Santa Clara, CA 95054 (US)
(72) Inventor: KANDULA, Rakesh, 560035 Bangalore (IN); TAN, Huah Yuah, 11900 Bayan Lepas (MY)
(74) Representative: HGF

(57) **Abstract**

In some embodiments, circuitry for implementing programmable die-to-die path test patterns is provided. A D2D link may include latches for transmitting data through a path between first and second dies and also may include transmit and receive test control circuits for programming desired patterns to be driven through the path in order to test it.

## Description

### TECHNICAL FIELD

Embodiments of the invention relate to the field of semiconductor devices; and more specifically, to the field of testing circuit paths.

### BRIEF DESCRIPTION OF THE DRAWINGS

The disclosure may best be understood by referring to the following description and accompanying drawings that are used to illustrate embodiments of the invention. In the drawings:
Fig. 1 is a side block view of a multi chip integrated circuit (IC) package in accordance with some embodiments.
Fig. 2 is a top view diagram showing two linked together dies in an exemplary multi-die package in accordance with some embodiments.
Fig 3 is a schematic diagram generally showing a section of a D2D cluster in accordance with some embodiments.
Fig. 4 is a flow diagram illustrating a routine 400 for performing path tests in accordance with some embodiments.
Fig. 5 is a schematic diagram showing a circuit for a single lane in a D2D interconnect link in accordance with some embodiments.
Fig. 6 is a schematic of a portion of a D2D section with a programmable test pattern circuit for an asymmetric DDR implementation in accordance with some embodiments.
Fig. 7 is a block diagram of a portion of a processor system with a circuit to program and control Tx and Rx test circuits in accordance with some embodiments.
Fig. 8 illustrates an example computing system that may be implemented at least in part with a multi-die package in accordance with some embodiments.

### DETAILED DESCRIPTION

With some high speed die to die (D2D) communication links in multi-die packages, synchronous gate to gate data paths may be employed. Such links can be effective in that they take up relatively little circuit resources and can transport large amounts of data at very high speeds with clocking speeds approaching or even exceeding 5 GHz. The transmission paths pass through die interface contacts such as micro bumps or hybrid bond interconnect (HBI) contact connections that can have defects and thus, the paths may need to be tested, not only during manufacture, but also, in the field even after they have been in use. Accordingly, their transmit and receive circuits typically include test circuits to test the transmission paths. For example, they have included fixed pattern or random pattern generators fixed inside the hardware that in many cases, cannot be changed once the integrated circuits have been made.

It has been observed that this can be problematic in that different types of defects may be better tested using different patterns. In addition, as components age, some link pathways, depending on the types of technologies used to make and implement them, may also be better tested using different patterns, or other test conditions, than were used when the product was new.

Accordingly, in some embodiments, test circuits and methods may be provided that allow for D2D paths to be tested using programmable patterns and/or other test conditions. In this way, if a user realizes that testing should be done with a different pattern, even after a device such as a multi-die device has been packaged, a test with the different test pattern or conditions can be performed.

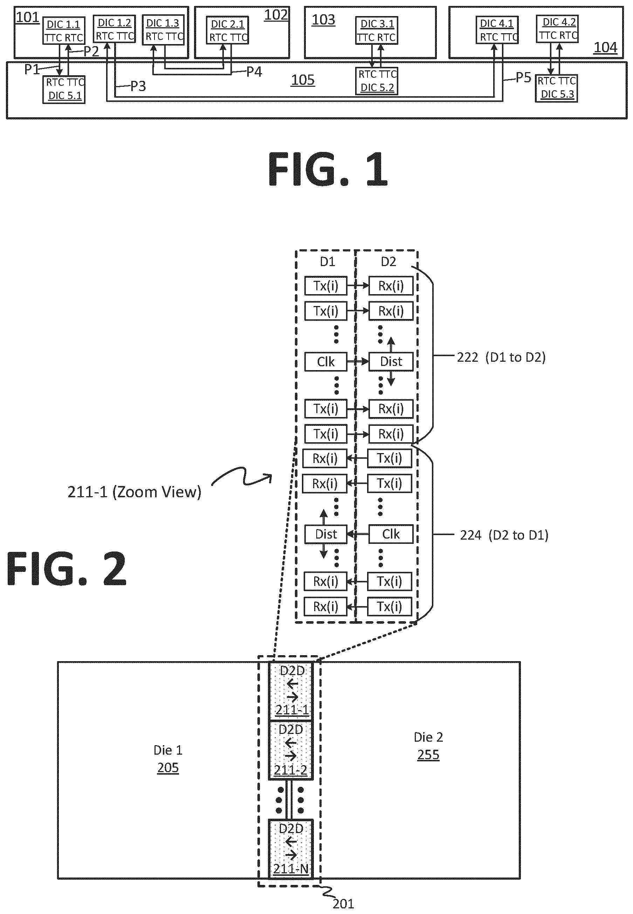

Fig. 1 is a side block view of a multi chip integrated circuit (IC) package in accordance with some embodiments. The depicted multi-die package has five separate dies (also known as dielets or chiplets) 101, 102, 103, 104, and 105. Die 105 serves as a base substrate with the other four dies (101-104) mounted atop it, e.g., using a hybrid bonding interconnect (HBI) technique. Each of the dies may be implemented with any die type (e.g., structure, process) or functionality such as a system on chip (SoC), graphics processing unit (GPU), input/output (IO) extension, applications processing unit (APU), high-performance compute, accelerator, artificial intelligence (AI), memory, or the like. For example, in some embodiments, base die 105 may implement high volume memory and also provide D2D path traces and connections, while dies 101 through 104 may implement SoC, IO expansion, compute, graphics, and IO integrated circuit devices to implement a high-performance compute processing package.

Each of the five depicted dies has a die interconnect circuit (DIC) to communicatively link the die with at least one other die. Apart from operational transmit (Tx) and receive (Rx) circuit (not expressly indicated), pertinent to this disclosure, the die interconnect circuits (DICs) also may have a transmit test circuit (TTC), a receive test circuit (RTC), or both a TTC and RTC to test the paths (or lanes) within the various D2D links. In the depicted embodiment, these D2D paths are represented with arrows connecting the Tx/Rx pairs. For example, a path linking DIC 1.1 Tx to DIC 5.1 Rx is indicated with P1. Similarly, P2 indicates a path linking the Tx from DIC 5.1 to the Rx in DIC 1.1. The paths correspond to the conductive paths, channels, including contacts, vias, traces, and/or wires within the dies, or die substrates/packages. Some of the paths may be relatively short such as P1, P2, while others may be longer such as with P4 or P5.

The TTCs and RTCs have memory for receiving programmed test patterns, although different patterns may be used for each path. When a test is to be performed, the TTC in a DIC sends its test pattern to its counterpart RTC in the other DIC on the path. The RTC compares the received pattern with its programmed expected pattern. If there is a difference, then the path may be defective or at least warrant further testing.

Fig. 2 is a top view diagram showing two linked together dies in an exemplary multi-die package in accordance with some embodiments. The figure illustrates a first die 205 coupled to a second die 255 through a die-to-die (D2D) link 201 that is formed from a plurality of D2D lane clusters (211-1 to 211-N) with each cluster having multiple single-direction Tx-Rx lanes for transmitting data in both directions between the first and second dies. The Tx and Rx circuits also have test circuits for testing the transmission paths (or channels) used to couple together Tx/Rx pairs in accordance with some embodiments.

A zoomed view of one of the clusters (211-1) is depicted in the figure. The cluster (211-1 in this example) includes a first section 222 for transmitting data from Die 1 to Die 2 and a second section 224 for transmitting data from Die 2 to Die 1. Each section has a multiplicity of Tx circuits and a clock (CLK) circuit, on one die, to convey data and a clock signal over the paths to corresponding receiver (Rx) circuits on the other die. The Rx circuits are clocked using the clock that is received from the Tx side of their transmission paths. So, in this implementation, each cluster has a plurality of Tx/Rx lanes, with a shared forwarded clock, to transmit data from a first die to a second die and a plurality of Tx/Rx lanes, with another shared clock, to transmit data in the opposite direction from the second die to the first die. (It should be appreciated that while depicted clusters are shown with symmetrical sections for transmitting data in both directions between two dies, there may be some embodiments where there may be more or less transmission paths in one direction or the other. In fact, in some embodiments, a DIC may not even have both a Tx and an Rx. In some cases, a D2D link may transmit data in only one direction and thus, a first die might have a DIC with TX circuit, without Rx circuit, while its counterpart DIC may have a Rx to receive the data on the link but not have Tx circuit. This may occur, for example, with multi-die packages having dies with different numbers of source and destination DICs for implementing the different D2D link pathways that may be desired in a multi-die package system. Note also that even with unidirectional D2D links, some data may actually be sent back through the link in the opposite direction such as with some side channels or feedback lanes for overseeing or otherwise administering data transmission operability.

The transmission paths may include any combination of wires, traces, contacts such as bumps, balls, or pads and/or any other suitable structures. For example, they may be coupled together through metal layer traces and vias that are embedded within a die substrate, interposer, bridge or any other suitable structure. Along these lines, it should be appreciated that any suitable structures may be used for connecting dies or die packages to each other through Tx/Rx channels as described herein. For example, wafer-level fan-out redistribution, using reconstituted wafer substrates of molding compounds as a surface for interconnections between dies may be used in 2.5D, 3D or hybrid implementations. Similarly, with some methods, a separate, usually silicon-based, interconnect layer for redistribution could be used. For example, either an interposer (passive and/or active, typically formed from silicon) or die-to-die bridges (e.g., such as silicon bridges embedded in an organic surface (e.g., substrate surface or interposer) could be employed. In some schemes, the metal-layer sides of dies may be directly connected to one another, e.g., through hybrid bonding or other contact-to-contact techniques. It may be desirable to couple together dies or die packages such as when they are made by different original equipment manufactures. For example, a compute module could be formed from connecting together on a common substrate or base die graphics processors from one supplier and central processors or system on chips (SoCs) from another supplier. And, as mentioned already, so-called hybrid bonding techniques may be employed to connect dies to each other directly through their hybrid bond contacts. Note that as used herein, a common contact resulting from the merger of two separate contacts, as when a first die's contacts are bonded with counterpart contacts from a second die, is assumed to retain at least some of the constituent contacts from the separate dies in the sense that even after a first die has been connected to a second die, there is still a first die with a first die contact and a second die with a second die contact even after the first and second die contacts have merged, or otherwise joined, together forming a contact connection, in connecting the first die to the second die.

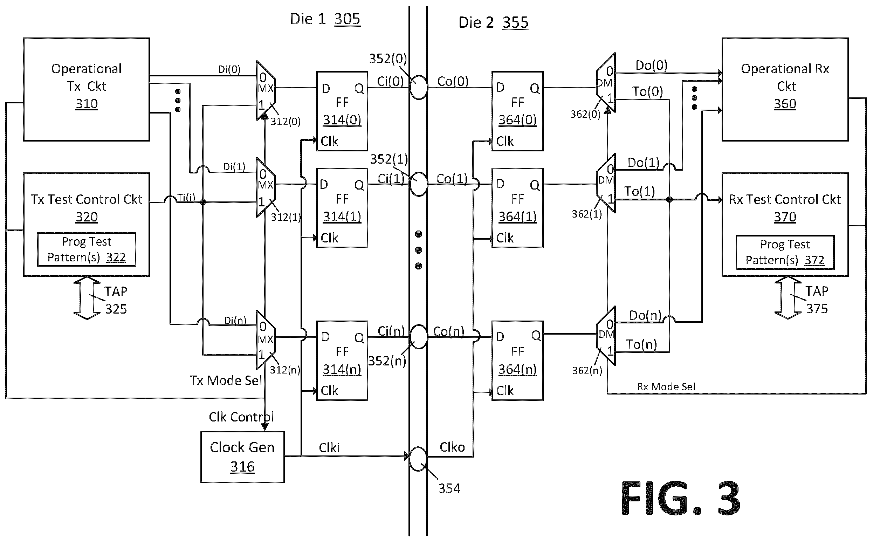

Fig 3 is a schematic diagram generally showing a section of a D2D cluster in accordance with some embodiments. The depicted cluster section is for transmitting data from a first die 305 to a second die 355. The D2D cluster section generally includes "n" data lanes and a clock lane for clocking the data lanes to transmit data from the first die to the second die. The first die 305 has operational transmitter control circuit 310, 2:1 mode select multiplexers (or switches) 312, transmitter latch circuits 314, a clock generation circuit 316, and a transmitter test control circuit 320 coupled together as shown. Likewise, the second die 355 includes operational receiver circuit 360, 1:2 demultiplexers (or switches) 362, data receiver latch circuits 364, and receiver test control circuit 370 coupled together as shown.

The data lanes are formed from the transmitter latches 314(0)-314(n) coupled to corresponding receiver latches 364(0)-364(n) through die-connecting contacts 352(0)-352(n). Data from the transmitter latches 314 is conveyed (or clocked) to the receiver latches 364 by a clock (CLK) that is generated by clock generator circuit 316, coupled to the transmitter latches 314 and also coupled (directly or indirectly) to the receiver latches 364 through a contact connection 354.

(As used herein, a multiplexer (or "Mux") is a type of switch that has an output and two or more inputs that may be selectively controlled to be coupled with its output. Likewise, a demultiplexer (or "Dmux") is a type of switch that has an input and two or more outputs that may be selectively controlled to be coupled with its input. A latch is a sequential digital circuit that receives a data input and uses a clock to convey data from the input to an output. A flip-flop is a type of latch that is typically clocked off of a clock edge while latches may allow data to pass from input to output while its clock is asserted, high or low. As used herein, however, a latch may be clocked off of a pulse, a clock edge or a sustained clock state, depending on design considerations such as operating frequencies, timing reliability, alignment tolerances, etc.)

On the transmitter side, the data lanes include multiplexers (Muxes) 312 coupled to the transmitter latches 314 to provide to them either data signals, Di(0)-Di(n), from the operational transmitter circuit 310 or test signals Ti(i) from the transmitter test control circuit 320, depending on the state of a mode select (Tx Mode Sel) signal provided to each of the multiplexers 312. The selected signals (data or test) are driven by the transmitter latches and provided as inputs Ci(0)-Ci(n) to the lane channels defined through contacts 352.

On the receiver side, the lanes include the receiver latches 364 coupled to the demultiplexers 362 to provide to them channel output signals Co(0)-Co(n) received from the transmitter latches 314. From here, depending on the state of the receiver mode select signal (Rx Mode Sel), the channel outputs are provided either as data outputs Do(0)-Do(n) to the operational receiver circuit 360 or as test signals To(0)-To(n) to the receiver test control circuit 370.

Under normal data transmission operation, the Rx and Rx mode select signals are selected to convey data from the operational transmitter circuit 310 to the operational receiver circuit 360 through the latches and channel paths. Alternatively, when the lane channel pathways are tested, the Tx and Rx mode select signals select test data to be conveyed from the transmitter test control circuit 320 through the channel pathways to the receiver test control circuit 370.

The transmitter test control circuit 320 has a programmable test pattern circuit 322 for storing and conveying one or more programmable transmit test patterns. It also has a test access port (TAP) 325 to program and control the programmable test pattern circuit 322. Similarly, the receiver test control circuit 370 has an expected test pattern circuit 372 for storing and comparing the one or more programmable expected test patterns against the programmable transmit test pattern received from the transmitter test control circuit. The receiver test control circuit also has a test access port (TAP) 375 to program and control the expected test pattern circuit 372.

The TAPs (325, 375) may be implemented with any suitable port structures, custom or in compliance with a known standard for use during a manufacture process and/or in the field. In some embodiments, a JTAG (Joint Test Access Group) test port architecture may be employed. (A JTAG interface is an interface used in a chip. Depending on the version of JTAG, two, four, or five pins may be used. The four and five pin interfaces may be designed so that multiple chips within a package can have their JTAG lines daisy-chained together or, as with some two pin interface designs, multiple chips can be connected in a star topology. In either case, an external test system interface for controlling the TAPs in the different DICs need only couple to a single "JTAG port" to have access to multiple dies within a multi-die module, although separate external access interfaces may also be used. Aspects of any suitable JTAG standard such as IEEE (Institute of Electrical and Electronics Engineers) 1149.1 or IEEE 1838, which builds on test standards such as IEEE 1149.1, IEEE 1500, and other standards may be employed. Alternatively, or in addition to, other test port interface standards may be used such as Serial Wire Debug (SWD)).

Returning back to Fig. 3, a shared signal line is shown for the test signals coming out of the Tx test control circuit and coming into the Rx test control circuit. This may be implemented using a time multiplexing scheme for testing the various channel paths. That is, the tests for each lane could be performed separately, apart from one another if problematic loading is avoided, e.g., by using separate mode select signals for the multiplexers and demultiplexers and/or other circuit components. This may be beneficial for reducing a required number of test signal traces and switch circuits required within the test control circuits themselves. Even if separate dedicated test lines for each channel are used, the tests may still be time multiplexed so that separate test pattern circuit such as generators, registers and comparators are not required for each lane. Specific implementations will likely depend upon specific design considerations and objectives.

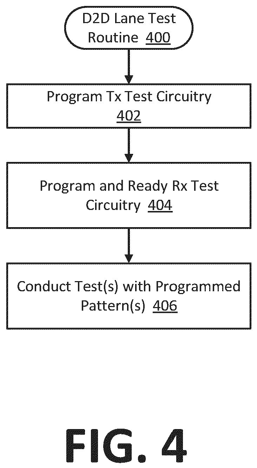

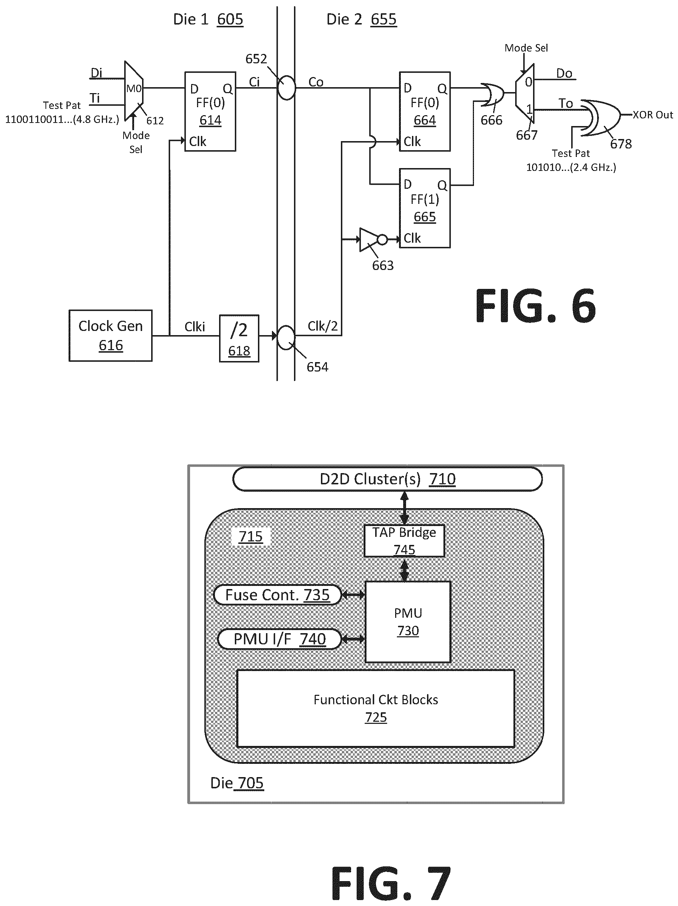

Fig. 4 is a flow diagram illustrating a routine 400 for performing path tests in accordance with some embodiments. At 402, a user programs the transmitter test control circuit with a desired transmit test pattern for a particular path, or path type, test. For example, as multi-die bonding technologies emerge, contact technologies (bumps, hybrid bonding, copper pillar bonding, etc.) change and eventually the defect profiles change, resulting in some cases with a need to use different test patterns. Traditionally, this had required different testing architectures from one product to the next, but with a programmable test capability, test patterns may be configured for specific contact structures and changed over time for different products or for a given product as it ages. For example, for 25um bump pitch technology the majority of defects may be bridging Faults or wafer Xy misalignment. Different test patterns may be used to detect these defects. Thus, a programmed transmit test pattern may be based on a particular defect profiling scenario. For example, if a part has not significantly aged, a user may use a toggling pattern (e.g., 101010101). On the other hand, if the part is aged, a user may choose to test the lanes using a less-changing pattern such as 11111000001111100000 to effectively ease required impedance characteristics (e.g., reactance parameters) of a given set of paths. As will be seen below with regard to the example of Fig. 6, if a user is testing an double data rate (DDR) die crossing, then the programmed transmit or programmed expected pattern could be something like 110011001100 for one side and '101010. . . for the other side, depending on the particular circuit implementation. As should be appreciated, there may be a variety of different test patterns that can enhance identification of defect characteristics for different die-to-die paths.

At 404, the routine then programs the receiver test control circuit with a suitable expected pattern corresponding to the programmed transmit test pattern. The patterns may be the same so that the receiver side expected pattern aligns with the conveyed transmitter side test pattern. However, in some cases, they may be different, e.g., with some DDR schemes or when one or more dummy start bits may be added to account for delays or clock transitions, depending on specific design implementations.

At 406, the lane test is conducted. As such, the test pattern is clocked through the path under test from the transmitter side to the receiver side and once there, compared with the programmed expected pattern. If the patterns sufficiently align with one another, then the path is sound. Otherwise, a defect may be detected. If so, the test may be repeated or another pattern may be employed or a different (e.g., lower) clock frequency may be used to better diagnose the observed defect.

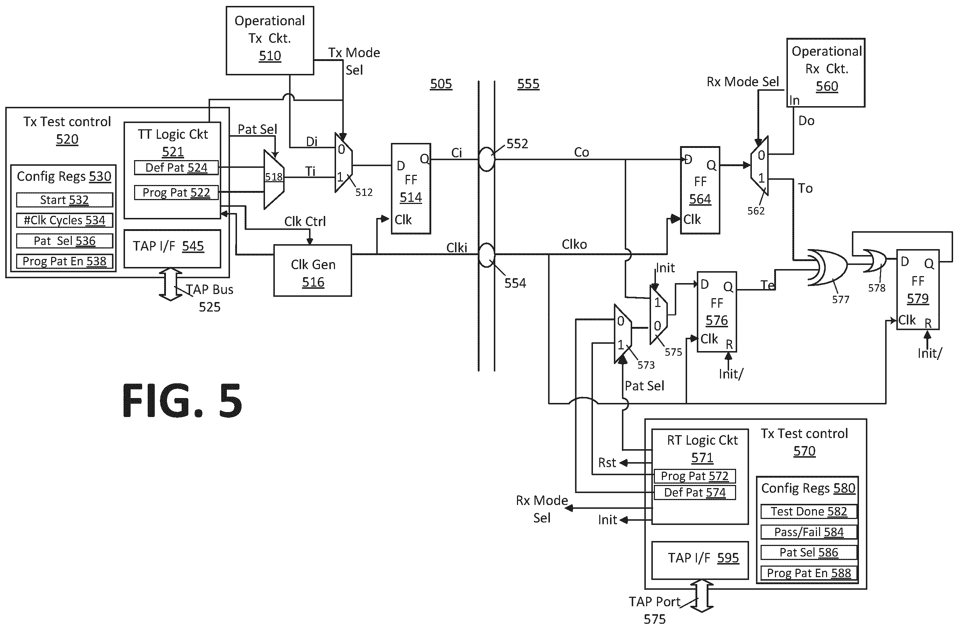

Fig. 5 is a schematic diagram showing a circuit for a single lane in a D2D interconnect link in accordance with some embodiments. There is transmitter side circuitry on a first die 505 and receiver side circuitry on a second die 555. In addition to having operational Tx circuit 510, a Tx mode select multiplexer 512, a transmitter latch 514, and a clock generator circuit 516, the transmitter side also has a pattern select latch 518 and a transmitter test control circuit 520 with test logic circuit 521, configuration registers 530, and TAP interface circuit 545 to facilitate test programming and control through a TAP (test access port) 525.

The Tx test logic circuit 521 includes a first memory circuit 522 to store a programmable transmitted test pattern and a second memory circuit 524 to store a default test pattern. The memory circuits may be implemented with any suitable circuits such as registers including shift registers, cache, buffers, or any other suitable programmable or read-only (e.g., default pattern) memory circuits.

The configuration registers 530 include a start register 532, a Clock cycles register (#Clk Cycles) 534, a pattern select register 536, and a programmable pattern enable register 538. The start register, when set (e.g., a flag programmed to '1) is used to initiate test pattern transmission after the Tx and Rx test control circuits have been programmed. The clock cycles register 534 stores a numeric value corresponding to the number of cycled test pattern bits that are to be clocked to the receiver test circuit. The pattern select register stores a value identifying a pattern to be used for testing. With the depicted example, this may be a single bit value to identify either the default pattern 524 or programmable transmitted test pattern 522. In other embodiments, however, additional patterns may be available, e.g., for different paths to be tested or for different types of tests to be conducted. The programmable test pattern enable register 538 stores a bit value used to enable programming of the programmable transmitted test pattern in the programmable test pattern register 522. When not set, it prevents the programmable transmitted test pattern from being inadvertently altered.

The TAP interface circuit 545 provides port control functionality to interface between the TAP (e.g., JTAG bus) and the Tx test logic circuit 521 and config. registers 530. Among other things, it may include a buffer with switch control logic to receive and parse commands and data to control, write to, and/or read from the registers and test logic circuit 521.

The test logic circuit 521 may be implemented with any suitable control circuit such as a micro-controller and/or one or more finite state machines to control the Tx mode select multiplexer(s), Tx latch(es) and the clock generator circuit to clock a test pattern to the receiver test circuit with appropriate alignment and timing.

On the second die 555, the circuit includes operational Rx circuit 560, a receiver demultiplexer 562, and a receiver latch 564. It also includes pattern selection and pattern comparison circuits, and a receiver test control circuit 570. The receiver test control circuit 570 has Rx test logic circuit 571, Rx configuration registers 580, and Rx TAP interface circuit 595 to facilitate test programming and control through a receiver side TAP 575.

The Rx test logic circuit 571 includes a first pattern memory circuit 572 to store a programmable expected test pattern and a second memory circuit 574 to store a default test pattern. As with the Tx test circuit, the test pattern memory circuits may be implemented with any suitable circuits such as registers including shift registers, cache, buffers, or any other suitable programmable or read-only (for the default pattern) memory circuits.

The configuration registers 580 include a Test Done register 582, a Pass/Fail register 584, a pattern select register 586, and a programmable pattern enable register 588. The Test Done register, when set (e.g., a flag programmed to '1) is used to indicate that a test has completed successfully, e.g., with a pass or fail result that may be indicated in the Pass/Fail register 584. The pattern select register 586 stores a value identifying an expected pattern to be used for testing. With the depicted example, this may be a single bit value to identify either the default pattern 574 or programmable pattern 572. In other embodiments, however, additional patterns may be available. The programmable test pattern enable register 588 stores a bit value used to enable programming of the programmable test pattern in the programmable expected test pattern register 572. When not set, it prevents the programmable expected test pattern from being inadvertently altered.

The TAP interface circuit 595 provides port control functionality to interface between the TAP (e.g., JTAG bus) and the Rx test logic circuit 571 and configuration registers 580. Among other things, it may include a buffer with switch control logic to receive and parse commands and data to control, write to, and/or read from the registers and test logic circuit.

The test logic circuit 571 may be implemented with any suitable control circuit such as a micro-controller and/or one or more finite state machines to control the Rx mode select multiplexer(s) and Rx latch(es) to receive a clocked test pattern from the transmitter test circuit with appropriate alignment and timing.

In the depicted embodiment, the pattern selection circuit includes a receiver pattern select multiplexer 573, and the pattern comparison circuit includes a test initiation multiplexer 575, an expected pattern latch 576, an XOR gate 577, an OR gate 578, and a results latch 579, all coupled together as shown, to compare a test signal pattern received from the Rx latch 562 with an expected test pattern from the Rx test control circuit 570.

The pattern select multiplexer 573, based on the pattern select register value 586, selects between the programmed pattern 572 and the default pattern 574. The test initiation mux 575 allows the Rx test control circuit to control when it should start comparing the data inputs at latches 572 and 576. That is, the Init signal serves as a control lever for the Rx control logic 571 to align the expected test pattern from the Rx circuit 570 with the received test signal (Co) from the Tx latch 514.

The XOR gate 577 compares the received test signal (To) with the expected test signal (Te) and asserts (e.g., '1) at its output if the signals are not the same but remains de-asserted (e.g., '0) if they are equivalent. This output is provided to one of the OR gate (578) inputs, while the other input is coupled to the output of results latch 579, causing it to serve as a "sticky" latch to record the result of the pattern comparisons. If every associated bits in the received and expected patterns are the same, then the output of results latch 579 will be de-asserted ('0) but if any one associated pair of bits are not the same, then the results latch 579 will assert, indicating a failed path test result. This result is stored in the Pass/Fail register 584. In the depicted embodiment, inverted versions of the Init signal are provided to reset inputs of the expected pattern latch 576 and results latch 579 to reset their outputs to a de-asserted state ('0) once the test has completed.

In operation, a user may initially program the Tx and Rx test control circuits, or they may already be programmed with a desired test pattern. If a pattern is to be programmed into the test pattern circuits (522, 572), the programmable test pattern enable flags (538, 588) are set and the patterns are programmed through the TAPs 525, 575. The test begins when the start register (or flag) 532 is set. This causes the Tx test logic circuit 521 to begin clocking a selected test pattern to the receiver test circuit. The pattern is transmitted for the programmed number of clock cycles as defined by register 534 and then stops when the Tx test logic circuit 521 gates off the Clk at clock generator 516. When this happens, the Rx test logic circuit 571 stores the output of the results latch 579 into the Pass/Fail register 584, sets the test done register 582 and de-asserts the Init signal to ready the Rx test circuit for another test. Note that the Pass/Fail register 584 may have a plurality of memory slots for storing multiple test results, for the same or for different paths to be tested. A user can read these results from the Rx TAP 575 immediately or scrape them from the Rx test control circuit 570 at a later time.

It should be appreciated that any suitable circuitry could be used for a received test pattern comparison circuit. In the depicted embodiment, test pattern timing and alignment is primarily controlled on the TX side by controlling the clock to transmit a specific number of test pattern bits by conducting a set number of clock cycles to the receiver side circuitry. Other schemes could be used. For example, the receiver side comparison circuitry could include a counter to count the expected number of received test pattern bits and then lock the results latch once the count has been reached. That is, timing and alignment could be controlled on the receiver side, as well as on the transmitter side depending on design considerations.

Fig. 6 is a schematic of a portion of a D2D section with a programmable test pattern circuit for an asymmetric DDR implementation in accordance with some embodiments. In this example, circuit components pertinent to DDR operation are shown while certain other components are omitted for convenience. This example illustrates how a test pattern may be defined to accommodate a double data rate (DDR) architecture. With this example, the Tx side has a Tx latch 614 driven by a clock from clock generator 616 with a frequency (F = 4.8 GHz in this example). The Tx side also includes a divide-by-2 frequency divider circuit 618 to provide a clock signal (Clk/2) having a frequency of F/2 to the Rx circuit. The Rx circuit includes first and second Rx latches, 664, 665, respectively, and an OR gate 666 to provide a received bit stream from the channel to a mode select mux 667. Bits are sampled from the received channel signal (Co) on both the rising and falling Rx side clock edges. Accordingly, there is the first Rx latch 664 to catch data on the rising Clk/2 edges, and the second Rx latch catches data on the falling Clk/2 edges. The OR gate 666 combines these out-of-phase signals into a resultant bit stream that is in turn provided to the mode select mux 667.

In this example, the Tx latches clock data over the channel on a single clock edge at a frequency of 4.8 GHz. However, the clock is divided in half at the Div/2 circuit 618 to more readily convey it across the die-to-die interface through contacts 654. So, on the Rx side, a normal toggle pattern (101010. . .) may be used at the Rx test comparison circuit (XOR gate 678), but a different test patter (11001100. . .) is used for the 4.8 GHz clocked circuit on the Tx side so that the compared test patterns align.

Fig. 7 is a block diagram of a portion of a processor system with a circuit to program and control Tx and Rx test circuits in accordance with some embodiments. The processor system includes a die (or dies) 705 with a D2D section(s) 710 coupled through a system fabric 715 to functional circuit blocks 725 and a power management unit (P)MU) 730. It also includes a TAP bridge circuit 745 to communicatively link the PMU 730 to one or more TAPs in the D2D section(s) 710 to among other things, program and control Tx and Rx test circuits for testing D2D paths between the section(s) 710 and D2D section(s) on other dies (not shown).

The functional circuit blocks 715 include the various different blocks that may be part of a processor system. For example, they may include compute cores, graphics processing cores, digital signal processing units, application specific circuits, security circuits, IO and memory controllers, and other intellectual property (IP) circuit blocks, depending on the specific functionality that is to be implemented on die 705.

The PMU 730 may include one or more microcontrollers, state machines and/or other logic circuits for controlling various aspects of the processor system. For example, it may manage functions such as security, boot configuration, and power and performance including utilized and allocated power, along with thermal management. The PMU may also be referred to as a P-unit, a power control unit (PCU), a system management unit (SMU) and the like and may work in cooperation with other PMUs or die management controllers across multiple dies and/or die packages within the processor system 100. The PMU may execute PMU code (not shown), which may include multiple separate software and/or firmware modules to perform these and other functions.

In the depicted embodiment, the PMU 730 is coupled with a fuse controller 735 and a PMU interface 740. The fuse controller may provide fused and/or other programmed parameters such as operating points for the specific die and in some embodiments, test patterns or other test data that may be used by the D2D Tx and Rx test circuit as described herein. The PMU interface 740 facilitates communications to the PMU from outside of the processor system, e.g., through a BIOS, dynamic OS-based write, e.g., MMIO write, mailbox transaction, or the like. To facilitate this, it may include one or more registers such as BIOS or other registers, for example, that may be implemented as so-called model specific registers (MSRs). Other interface schemes may be used such as memory management input/output (MMIO) writes. Through the PMU interface 740, users such as end users or OEMs may program and control D2D path tests as discussed herein. To do so, the Tx and Rx test control circuits may be programmed by the PMU through the bridge 745, which converts PMU protocol command/data to a protocol for the utilized test access ports (TAPs) such as JTAG protocol. For example, with JTAG interfaces/ports, the bridge 745 may function as a JTAG adapter using JTAG as a transport mechanism to access on-chip debug modules such as the Rx and Rx test circuits.

For example, programmed transmit test patterns can be changed in the field by using a PMU firmware patch if the OEM or user believes that infield testing should be done with a different pattern. For example, to implement a new test, the PMU may find a partition that has a D2D path crossing to be IDLE. Next, the PMU issues commands to program the Tx and Rx test control registers inside test circuit for paths to be tested. Next, the commands are conveyed by the PMU and converted by the TAP bridge into utilized TAP command/data formats and programmed through the TAPs to the test circuits.

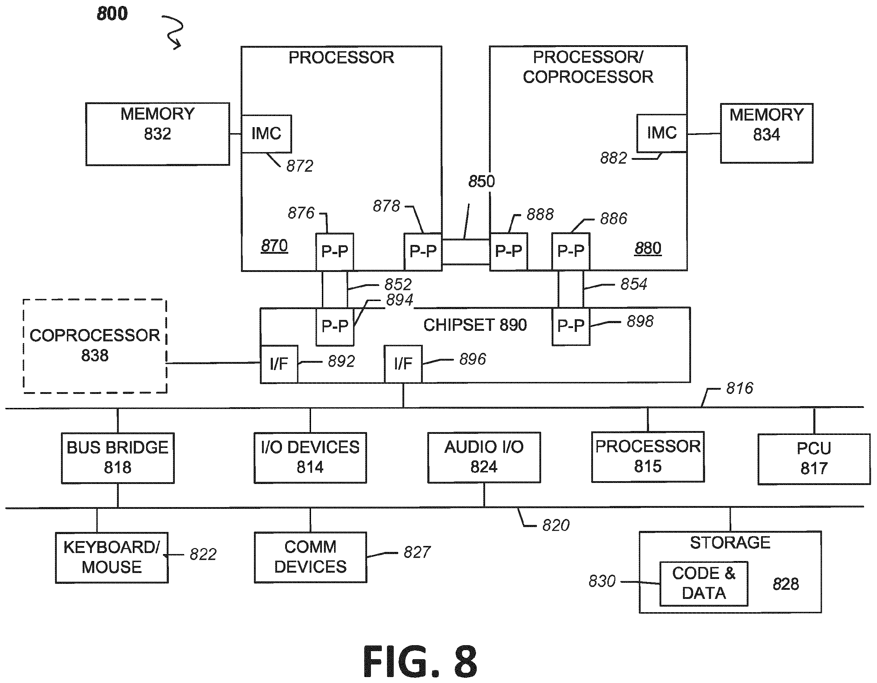

Fig. 8 illustrates an example computing system that may be implemented at least in part with a multi-die package in accordance with some embodiments. Multiprocessor system 800 is an interfaced system and includes a plurality of processors including a first processor 870 and a second processor 880 coupled via an interface 850 such as a point-to-point (P-P) interconnect, a fabric, and/or bus. In some examples, the first processor 870 and the second processor 880 are homogeneous. In some examples, first processor 870 and the second processor 880 are heterogenous. Though the example system 800 is shown to have two processors, the system may have three or more processors, or may be a single processor system. In some examples, the computing system is implemented, wholly or partially, with a system on a chip (SoC) or a multi-chip (or multi-chiplet) module, in the same or in different package combinations.

Processors 870 and 880 are shown including integrated memory controller (IMC) circuitry 872 and 882, respectively. Processor 870 also includes interface circuits 876 and 878, along with core sets. Similarly, second processor 880 includes interface circuits 886 and 888, along with a core set as well. A core set generally refers to one or more compute cores that may or may not be grouped into different clusters, hierarchal groups, or groups of common core types. Cores may be configured differently for performing different functions and/or instructions at different performance and/or power levels. The processors may also include other blocks such as memory and other processing unit engines.

Processors 870, 880 may exchange information via the interface 850 using interface circuits 878, 888. IMCs 872 and 882 couple the processors 870, 880 to respective memories, namely a memory 832 and a memory 834, which may be portions of main memory locally attached to the respective processors.

Processors 870, 880 may each exchange information with a network interface (NW I/F) 890 via individual interfaces 852, 854 using interface circuits 876, 894, 886, 898. The network interface 890 (e.g., one or more of an interconnect, bus, and/or fabric, and in some examples is a chipset) may optionally exchange information with a coprocessor 838 via an interface circuit 892. In some examples, the coprocessor 838 is a special-purpose processor, such as, for example, a high-throughput processor, a network or communication processor, compression engine, graphics processor, general purpose graphics processing unit (GPGPU), neural-network processing unit (NPU), embedded processor, or the like.

A shared cache (not shown) may be included in either processor 870, 880 or outside of both processors, yet connected with the processors via an interface such as P-P interconnect, such that either or both processors' local cache information may be stored in the shared cache if a processor is placed into a low power mode.

Network interface 890 may be coupled to a first interface 816 via interface circuit 896. In some examples, first interface 816 may be an interface such as a Peripheral Component Interconnect (PCI) interconnect, a PCI Express interconnect, or another I/O interconnect. In some examples, first interface 816 is coupled to a power control unit (PCU) 817, which may include circuitry, software, and/or firmware to perform power management operations with regard to the processors 870, 880 and/or co-processor 838. PCU 817 provides control information to one or more voltage regulators (not shown) to cause the voltage regulator(s) to generate the appropriate regulated voltage(s). PCU 817 also provides control information to control the operating voltage generated. In various examples, PCU 817 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 817 is illustrated as being present as logic separate from the processor 870 and/or processor 880. In other cases, PCU 817 may execute on a given one or more of cores (not shown) of processor 870 or 880. In some cases, PCU 817 may be implemented as a microcontroller (dedicated or general-purpose) or other control logic configured to execute its own dedicated power management code, sometimes referred to as P-code. In yet other examples, power management operations to be performed by PCU 817 may be implemented externally to a processor, such as by way of a separate power management integrated circuit (PMIC) or another component external to the processor. In yet other examples, power management operations to be performed by PCU 817 may be implemented within BIOS or other system software. Along these lines, power management may be performed in concert with other power control units implemented autonomously or semi-autonomously, e.g., as controllers or executing software in cores, clusters, IP blocks and/or in other parts of the overall system.

Various I/O devices 814 may be coupled to first interface 816, along with a bus bridge 818 which couples first interface 816 to a second interface 820. In some examples, one or more additional processor(s) 815, such as coprocessors, high throughput many integrated core (MIC) processors, GPGPUs, accelerators (such as graphics accelerators or digital signal processing (DSP) units), field programmable gate arrays (FPGAs), or any other processor, are coupled to first interface 816. In some examples, second interface 820 may be a low pin count (LPC) interface. Various devices may be coupled to second interface 820 including, for example, a keyboard and/or mouse 822, communication devices 827 and storage circuitry 828. Storage circuitry 828 may be one or more non-transitory machine-readable storage media as described below, such as a disk drive or other mass storage device which may include instructions/code and data 830 and may implement the storage in some examples. Further, an audio I/O 824 may be coupled to second interface 820. Note that other architectures than the point-to-point architecture described above are possible. For example, instead of the point-to-point architecture, a system such as multiprocessor system 800 may implement a multi-drop interface or other such architecture.

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput) computing. Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip (SoC) that may be included on the same die as the described CPU (sometimes referred to as the application core(s) or application processor(s)), the above described coprocessor, and additional functionality.

Illustrative examples of the technologies disclosed herein are provided below. An embodiment of the technologies may include any one or more, and any compatible combination of, the examples described below.

Example 1 is an apparatus that includes a switch, a latch and a transmitter test control circuit. The switch has a first input coupled to an operational data node and a second input coupled to a test data node. The switch also has a switch output. The latch has a latch input coupled to the switch output and a latch output coupled to a first die contact. The transmitter test control circuit has a programmable test pattern memory circuit coupled to the test data node to provide a programmed transmit test pattern through the latch and first die contact to a second die latch through a second die contact once the second die contact is connected with the first die contact.

Example 2 includes the subject matter of example 1, and wherein the programmed transmit test pattern is a selected one of two or more different test patterns to test a connection between the first and second die contacts.

Example 3 includes the subject matter of any of examples 1-2, and wherein the transmitter test control circuit has a programmable clock cycles memory circuit to identify a number of clock cycles for the programmed transmit test pattern.

Example 4 includes the subject matter of any of examples 1-3, and wherein the transmitter test control circuit is coupled to a clock generator circuit to control a clock driving the first latch based on the number of clock cycles in the programmable clock cycles memory circuit.

Example 5 includes the subject matter of any of examples 1-4, and wherein the transmitter test control circuit has a default test pattern memory circuit to provide a default test pattern to the test data node when selected.

Example 6 includes the subject matter of any of examples 1-5, and wherein the transmitter test control circuit has a test access port circuit to enable a user to program the programmable test pattern.

Example 7 is a multi-die integrated circuit (IC) package that has a circuit in accordance with the subject matter of any of examples 1-7.

Example 8 is an apparatus that includes a latch, a switch, a comparison circuit, and a receiver test control circuit. The latch circuit has (i) a latch input coupled to a first die contact, and (ii) a latch output. The switch has (i) a switch input coupled to the first latch output, (ii) a first switch output coupled to an operational data node, and (iii) a second switch output coupled to a received test data node. The comparison circuit has (i) a first comparison input coupled to the received test data node and (ii) a second comparison input. The receiver test control circuit has a programmable expected test pattern memory circuit coupled to the second comparison input to provide it with an expected test pattern. The received test data node is to receive a programmed transmit test pattern from a second die contact on a second die.

Example 9 includes the subject matter of example 8, and wherein the expected test pattern is a selected one of two or more different test patterns to test a connection between the first and second die contacts.

Example 10 includes the subject matter of any of examples 8-9, and wherein the receiver test control circuit has a default test pattern memory circuit to provide a default test pattern to the comparison circuit when selected.

Example 11 includes the subject matter of any of examples 8-10, and wherein the receiver test control circuit has a test access port circuit to enable a user to program the expected test pattern.

Example 12 includes the subject matter of any of examples 8-11, and wherein the comparison circuit has XOR logic circuitry to compare the received test pattern with the expected test pattern.

Example 13 includes the subject matter of any of examples 8-12, and wherein the comparison circuit has an initiation latch to control when the XOR logic circuitry is to actively compare received and expected test pattern data.

Example 14 includes the subject matter of any of examples 8-13, and wherein the comparison circuit has a results latch coupled to the XOR logic circuitry to store a comparison result.

Example 15 includes the subject matter of any of examples 8-14, and wherein the comparison circuit has a counter circuit coupled to the results latch to lock the comparison result upon receipt of a number of clock cycles.

Example 16 is an apparatus that includes first and second dies. The first die has a transmitter circuit, and the second die has a receiver circuit coupled to the transmitter circuit through a data contact connection. The transmitter circuit includes a Tx latch and a transmitter test control circuit. The Tx latch has (i) a Tx latch input coupled to a test pattern node, and (ii) a Tx latch output coupled to the data contact connection. The transmitter test control circuit has a programmable test pattern memory circuit coupled to the test pattern node to provide a programmed transmit test pattern to the data contact connection through the Tx latch. The receiver circuit has an Rx latch, a comparison circuit, and a receiver test control circuit. The Rx latch has (i) an Rx latch input coupled to the data contact connection to receive the programmed transmit test pattern and (ii) an Rx latch output. The comparison circuit has (i) a first comparison input coupled to the Rx latch output, and (ii) a second comparison input. The receiver test control circuit has a programmable expected test pattern memory circuit coupled to the second comparison input to provide it with an expected test pattern to be compared against the received programmed transmit test pattern.

Example 17 includes the subject matter of example 16, and wherein the programmed transmit test pattern is a selected one of two or more different test patterns to test a connection between first and second die contacts that make up the data contact connection.

Example 18 includes the subject matter of any of examples 16-17, and wherein the transmitter test control circuit has a programmable clock cycles memory circuit to identify a number of clock cycles for the programmed transmit test pattern.

Example 19 includes the subject matter of any of examples 16-18, and wherein the transmitter test control circuit is coupled to a clock generator circuit to control a clock driving the Tx latch based on the number of clock cycles in the programmable clock cycles memory circuit.

Example 20 includes the subject matter of any of examples 16-19, and wherein the transmitter test control circuit has a default test pattern memory circuit to provide a default test pattern to the test data node when selected.

Example 21 includes the subject matter of any of examples 16-20, and wherein the transmitter test control circuit has a test access port circuit to enable a user to program the programmable test pattern.

Example 22 includes the subject matter of any of examples 16-21, and wherein the receiver test control circuit has a test access port circuit to enable a user to program the programmable expected test pattern.

Example 23 includes the subject matter of any of examples 16-22, and wherein the comparison circuit has XOR logic circuitry to compare the received test pattern with the expected test pattern.

Example 24 includes the subject matter of any of examples 16-23, and wherein the comparison circuit has an initiation latch to control when the XOR logic circuitry is to actively compare received and expected test pattern data.

Example 25 includes the subject matter of any of examples 16-24, and wherein the comparison circuit has a results latch coupled to the XOR logic circuitry to store a comparison result.

Example 26 includes the subject matter of any of examples 16-25, and wherein the comparison circuit has a counter circuit coupled to the results latch to lock the comparison result upon receipt of a number of clock cycles.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "circuit" or "module" may refer to one or more passive and/or active components that are arranged to cooperate with one another to provide a desired function. It should be appreciated that different circuits or modules may consist of separate components, they may include both distinct and shared components, or they may consist of the same components. For example, A controller circuit may be a first circuit for performing a first function, and at the same time, it may be a second controller circuit for performing a second function, related or not related to the first function.

The meaning of "in" includes "in" and "on" unless expressly distinguished for a specific description.

The terms "substantially," "close," "approximately," "near," and "about," unless otherwise indicated, generally refer to being within +/-10% of a target value.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

For purposes of the embodiments, unless expressly described differently, the transistors in various circuits and logic blocks described herein may be implemented with any suitable transistor type such as field effect transistors (FETs) or bipolar type transistors. FET transistor types may include but are not limited to metal oxide semiconductor (MOS) type FETs such as tri-gate, FinFET, and gate all around (GAA) FET transistors, as well as tunneling FET (TFET) transistors, ferroelectric FET (FeFET) transistors, or other transistor device types such as carbon nanotubes or spintronic devices.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are dependent upon the platform within which the present disclosure is to be implemented.

As defined herein, the term "if" means "when" or "upon" or "in response to" or "responsive to," depending upon the context. Thus, the phrase "if it is determined" or "if [a stated condition or event] is detected" may be construed to mean "upon determining" or "in response to determining" or "upon detecting [the stated condition or event]" or "in response to detecting [the stated condition or event]" or "responsive to detecting [the stated condition or event]" depending on the context. As defined herein, the term "responsive to" means responding or reacting readily to an action or event. Thus, if a second action is performed "responsive to" a first action, there is a causal relationship between an occurrence of the first action and an occurrence of the second action. The term "responsive to" indicates the causal relationship.

As defined herein, the term "processor" means at least one hardware circuit configured to carry out instructions contained in program code. The hardware circuit may be implemented with one or more integrated circuits. Examples of a processor include, but are not limited to, a central processing unit (CPU), an array processor, a vector processor, a digital signal processor (DSP), a field-programmable gate array (FPGA), a programmable logic array (PLA), an application specific integrated circuit (ASIC), programmable logic circuitry, a graphics processing unit (GPU), a controller, a system on a chip (SoC), an application processor, an integrated circuit incorporating a combination of one or more of the aforesaid items, etc.

While the flow diagrams in the figures show a particular order of operations performed by certain embodiments of the invention, it should be understood that such order is exemplary (e.g., alternative embodiments may perform the operations in a different order, combine certain operations, overlap certain operations, etc.).

While the invention has been described in terms of several embodiments, those skilled in the art will recognize that the invention is not limited to the embodiments described, can be practiced with modification and alteration within the spirit and scope of the appended claims. The description is thus to be regarded as illustrative instead of limiting.

## Claims

1. A transmitter test apparatus, comprising:
a switch having (i) a first input coupled to an operational data node, (ii) a second input coupled to a test data node, and(iii) a switch output
a latch having (i) a latch input coupled to the switch output and (ii) a latch output coupled to a first die contact; and
a transmitter test control circuit having a programmable test pattern memory circuit coupled to the test data node to provide a programmed test pattern through the latch and first die contact to a second die latch through a second die contact while the second die contact is connected with the first die contact.

2. The apparatus of claim 1, wherein the programmed test pattern is a selectable one of two or more different test patterns to test a connection between the first and second die contacts.

3. The apparatus of any of claims 1-2, wherein the transmitter test control circuit has a programmable clock cycles memory circuit to identify a number of clock cycles for the programmed test pattern.

4. The apparatus of claim 3, wherein the transmitter test control circuit is coupled to a clock generator circuit to control a clock driving the first latch based on the number of clock cycles in the programmable clock cycles memory circuit.

5. The apparatus of any of claims 1-4, wherein the transmitter test control circuit has a default test pattern memory circuit to provide a default test pattern to the test data node when selected.

6. The apparatus of any of claims 1-5, wherein the transmitter test control circuit has a test access port circuit to enable a user to program the programmable test pattern.

7. An integrated circuit (IC) including a test circuit in accordance with the apparatus of any of claims 1-6.

8. A receiver test apparatus, comprising:
a latch circuit having (i) a latch input coupled to a first die contact , and (ii) a latch output;
a switch having (i) a switch input coupled to the first latch output, (ii) a first switch output coupled to an operational data node, and (iii) a second switch output coupled to a received test data node;
a comparison circuit having (i) a first comparison input coupled to the received test data node and (ii) a second comparison input; and
a receiver test control circuit having a programmable expected test pattern memory circuit coupled to the second comparison input to provide it with an expected test pattern, the received test data node to receive a programmed test pattern from a second die contact on a second die.

9. The apparatus of claim 8, wherein the expected test pattern is a selected one of two or more different test patterns to test a connection between the first and second die contacts.

10. The apparatus of any of claims 8-9, wherein the receiver test control circuit has a default test pattern memory circuit to provide a default test pattern to the comparison circuit when selected.

11. The apparatus of any of claims 8-10, wherein the receiver test control circuit has a test access port circuit to enable a user to program the expected test pattern.

12. The apparatus of any of claims 8-11, wherein the comparison circuit has XOR logic circuitry to compare the received test pattern with the expected test pattern.

13. The apparatus of any of claims 8-12, wherein the comparison circuit has an initiation latch to control when the XOR logic circuitry is to actively compare received and expected test pattern data.

14. The apparatus of any of claims 12-13, wherein the comparison circuit has a results latch coupled to the XOR logic circuitry to hold a comparison result.

15. A multi-die integrated circuit package including a first die with a transmitter test circuit in accordance with any of claims 2-7 and a second die with a receiver test circuit coupled with the transmitter test circuit, the receiver test circuit in accordance with any of claims 8-14.
